# EUROPEAN PATENT APPLICATION

(11) **EP 1 179 734 A1**
(43) Date of publication of application: **13.02.2002**
(21) Application number: 01118596.4
(22) Date of filing: 02.08.2001
(51) Int. Cl.: G01R 1/073

(54) **Testing head having vertical probes**

(30) Priority: 04.08.2000 IT MI001835
(71) Applicant: Technoprobe S.r.l, 23870 Cernusco Lombardone (LC) (IT)
(72) Inventor: Felici, Stefano, 23899 Robbiate (Lecco) (IT); Crippa, Giuseppe, 23807 Merate (Lecco) (IT)
(74) Representative: Botti, Mario

(57) **Abstract**

The invention relates to a testing head (10) having vertical probes and comprising at least one guide plate (12) providing at least one guide hole (13) adapted to receive at least one contact probe (14) having at least one contact tip (16) suitable to mechanically and electrically contact a corresponding contact pad (17) of a device (11) to be tested.

Advantageously in this invention, the contact probe (14) has at least one pre-deformed section (15) placed in a flexion region (19) between the guide plate (12) and the device (11) to be tested, said pre-deformed section being able to deform further during the normal operation of the testing head (10) upon the contact tip (16) abutting against the contact pad (17) of the device (11) to be tested.

## Description

### Field of Application

The present invention relates to a testing head having vertical probes.

Specifically, the invention relates to a testing head having vertical probes and comprising at least one guide plate providing a guide hole adapted to receive at least one contact probe, in turn having at least one contact tip suitable to establish mechanical and electrical contact to a corresponding contact pad of a device to be tested.

The invention relates, particularly but not exclusively, to a testing head having vertical probes for use on semiconductor integrated devices, and the following description is made with reference to this application field for convenience of illustration only.

### Background Art

As is well known, a testing head is basically a device suitable to electrically interconnect a plurality of contact pads of a microstructure and the corresponding channels of a testing machine arranged to perform the tests.

Integrated circuits are factory tested in order to spot and reject any circuits that show out to be already defective during the manufacturing phase. The testing heads are normally employed to electrically test the integrated circuits "on wafer", prior to cutting and mounting them in a chip package.

A vertical probes testing head comprises at least a pair of parallel guide plates placed at a given distance apart to leave an air gap therebetween, and a plurality of specially provided movable contact elements. In particular, the guide plate pair comprises a top guide plate and a bottom guide plate, both plates being formed with guide holes receiving the movable contact elements for axial sliding movement therethrough, the contact elements being usually wires made of special alloys having good electrical and mechanical properties. These will be referred to as the testing head probes through the remainder of this description.

A good contact of the testing head probes with the contact pads of a device to be tested is achieved by urging the testing head against the device, with the movable contact probes flexed in the air gap between the two guide plates. Testing heads of this type are commonly known as "vertical probes".

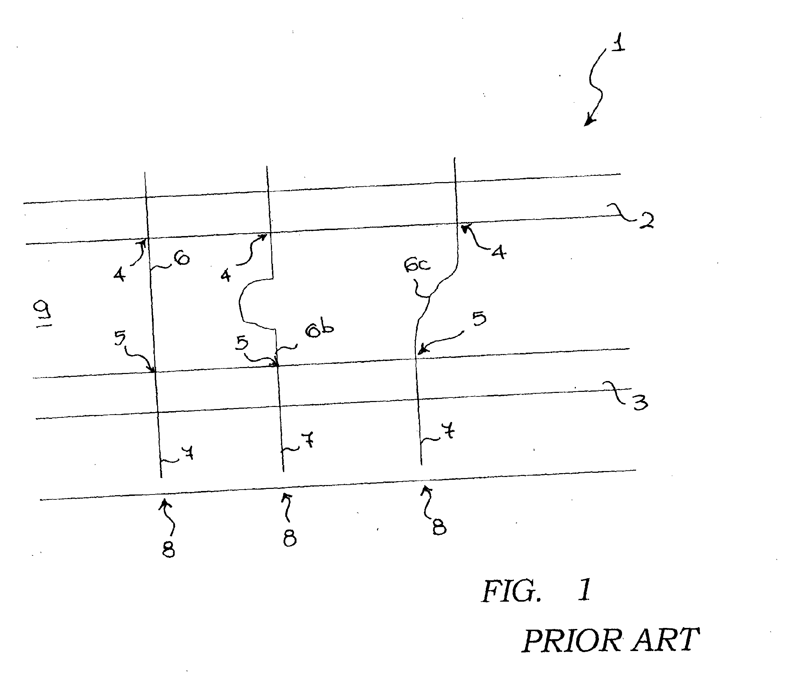

In other words, conventional testing heads have an air gap where the probes are flexed, with such flexion being assisted by a suitable configuration of the probes or their guide plates, as schematically shown in Figure 1.

As shown in Figure 1, a testing head 1 comprises at least a top guide plate 2 and a bottom guide plate 3, both formed with top 4 and bottom 5 guide holes, respectively, through which at least one contact probe 6 slides.

Each contact probe 6 has at least one contact end or tip 7. In particular, the contact tip 7 is caused to abut against a contact pad 8 of a device to be tested, thereby establishing a mechanical and electrical contact between said device and a testing apparatus (not shown) that has said testing head as end element.

The top and bottom guide plates 2 and 3 are suitably separated by an air space or gap 9 accommodating the deformation of the contact probe 6. Moreover, the top and bottom guide holes 4 and 5 are suitable sized to guide the contact probe 6.

The deformed pattern of the probes, and the force required to produce it, depend on a number of factors, such as:
- the physical characteristics of the alloy used in the construction of the probes; and
- the amount of offset between the guide holes in the top guide plate and the corresponding guide holes in the bottom guide plate, as well as the distance between such holes.

It should be noted that, for a correct testing head operation, the probes must have a suitable degree of free axial movement in the guide holes. In this way, the probes can also be taken out and replaced in the event of a single probe breaking, with no need to replace the whole testing head.

All these features are, therefore, to be taken into due account in the manufacture of a testing head, given that a good electric connection between the probes and the device to be tested is mandatory.

Also known is to use contact probes having a pre-deformed configuration even when the testing head 1 is not contacting the device to be tested, as in the probes 6b and 6c shown in Figure 1. This predeformation effectively helps the probe to correctly flex during its operation, i.e. upon contacting the device to be tested.

Thus, the correct operation of a testing head depends on the vertical movement, or overtravel, of its probes, and the horizontal movement, or scrub, of the probe contact tips.

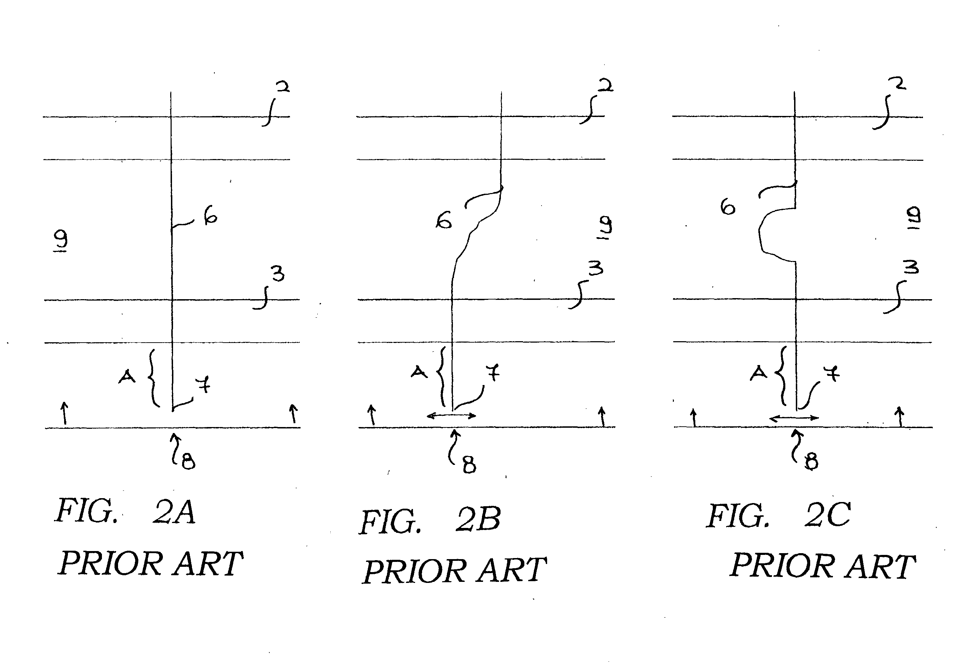

In conventional testing heads, these parameters have inherent limitations. As schematically shown in Figures 2A and 2B, the maximum overtravel of a probe is equal to the length of the probe portion A projecting out with respect to the bottom guide plate, this projecting portion A being retracted into the bottom guide plate as the testing head contacts the device to be tested, by virtue of the probe flexion and deformation.

However, the height of such projecting portion is limited by the probe fragility properties, and is usually 300 to 500µ.

In practice, the above overtravel amount of the probes is only theoretically achievable, and problems due to probes becoming stuck in their guide holes and due to the permanent deformation of the probes already arise for very small overtravel amounts.

This problem has been circumvented by using probes with a deformation in their section lying within the air gap, as schematically shown in Figure 2C. Such probes utilise almost all the overtravel of the projecting portion from the bottom guide plate, but are complicated to manufacture and maintain.

In addition, the bottom guide plate greatly restricts the horizontal movements of the probe tip, the extent of this movement or scrub being strictly dependent on the difference between the diameters of the hole and the probe.

In some cases, the contact probes are fixedly mounted to the top guide plate of the testing head. This arrangement is known as a testing head having clamped contact probes.

However, testing heads with loose-mounted probes are more widely employed, wherein the probes are interfaced to a "board" by a microcontact strip called the "space transformer". This is known as a testing head having no-clamped contact probes.

In the latter case, each contact probe has an additional contact tip pointing toward a plurality of contact pads provided on the space transformer. A good electric contact is established between the probes and the space transformer in a similar way as the contact to the device to be tested, i.e. by urging the probes against the contact pads on the space transformer.

The major advantage of a testing head having no-clamped contact probes is that one or more faulty probes, or the whole set of probes, can be replaced with greater ease than is allowed by testing heads having clamped contact probes.

In this case, however, the top and bottom guide plates must be designed to withhold the contact probes in place even while no device to be tested is abutting their contact tips, or when the whole set of probes is removed for replacement.

The underlying technical problem of this invention is to provide a testing head for microstructures, which has probes adapted to be deformed on touching contact pads to establish a good electric contact to a device to be tested, and adapted to be held in place without the assistance of a bottom guide plate.

### Summary of the Invention

The principle on which this invention stands is one of providing a testing head with a plurality of probes, each having a pre-deformed section between the testing head and the device to be tested.

Based on this principle, the technical problem is solved by a testing head as indicated comprising at least one guide plate formed with at least one guide hole adapted to receive at least one contact probe having at least one contact tip, the probe contact tip being suitable to mechanically and electrically contact a corresponding contact pad of a device to be tested, and said contact probe having at least one pre-deformed section within a probe flexion region between the guide plate and the device to be tested, said pre-deformed section able to further deform in normal operation of the testing head upon said contact tip abutting against said contact pad of the device to be tested, as defined in the characterising part of Claim 1.

The features and advantages of a testing head according to the invention will be apparent from the following description of embodiments thereof, given by way of non-limitative examples with reference to the accompanying drawings.

### Brief Description of the Drawings

In the drawings:
- Figure 1 schematically shows a first embodiment of a testing head according to the prior art;
- Figures 2A, 2B and 2C schematically show further embodiments of a testing head according to the prior art;
- Figure 3 schematically shows a testing head according to the invention;
- Figures 4A, 4B, 4C, 4D and 4E schematically show further embodiments of a testing head according to the invention;
- Figures 5A and 5B schematically show another embodiment of a testing head according to the invention;
- Figures 5C and 5D schematically show top plan views of alternative arrangements of a testing head according to the invention;
- Figures 6A and 6B schematically show further embodiments of a testing head according to the invention;
- Figures 7A, 7B, 7C and 7D schematically show further embodiments of a testing head according to the invention; and
- Figures 8A. 8B and 8C schematically show further embodiments of a testing head according to the invention;

### Detailed Description

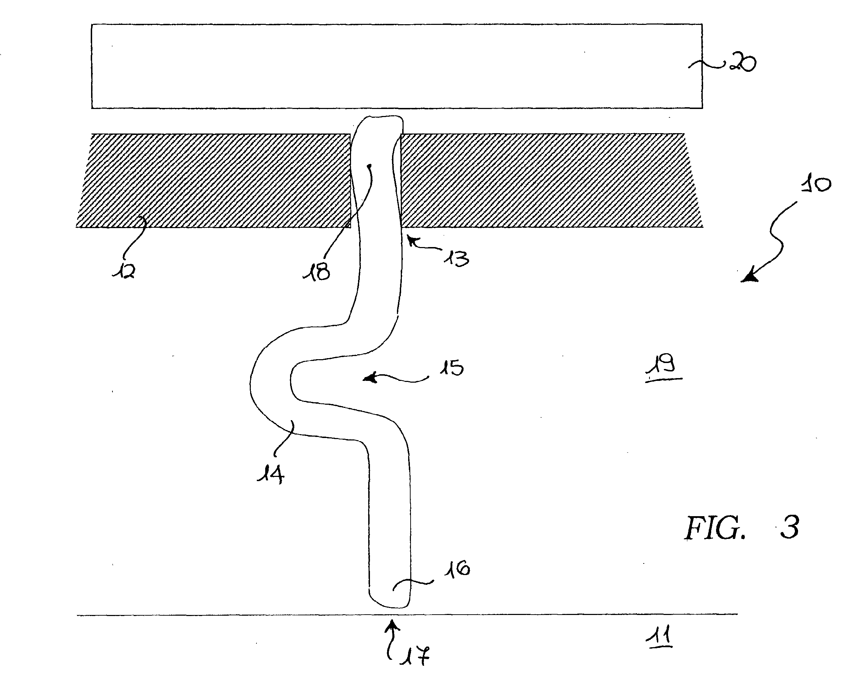

Schematically shown in Figure 3 is a testing head 10 according to the invention, suitable to be placed in contact with a device 11 to be tested.

The testing head 10 comprises at least one guide plate 12 formed with at least one guide hole 13 for receiving a contact probe 14.

The contact probe 14 has a symmetrical or asymmetrical pre-deformed section 15, placed in a flexion region 19 extending between the guide plate 12 and the device 11 to be tested. This pre-deformed section can also deform during normal operation of the testing head 10. In particular, the contact probe 14 has a contact end or tip 16 intended to abut against corresponding contact pads 17 of the device 11 to be tested and to cause a further deformation of the probe 14 at its pre-deformed section 15.

Shown in Figure 3 by way of example is a testing head 10 having no-clamped contact probes, wherein each probe has an additional contact tip 18 pointing toward a space transformer 20. Alternatively, it would be plainly possible to provide a testing head 10 having pre-deformed clamped probes.

Advantageously according to the invention, the flexion region 19 lies outside the testing head 10, between the guide plate 12 and the device 11 to be tested. In this way, the problems that beset conventional testing heads, due to probes becoming stuck in their guide holes, or due to the size of the air gap between the guide plates and, hence, the testing head space requirements, are overcome.

Furthermore, with the flexion region 19 placed outside the testing head 10, the amount of possible vertical movement or overtravel for the testing head 10 can be increased.

Moreover, the horizontal movement or scrub of the contact tip 16 on the contact pads 17 is easily controlled by suitably changing the size and shape of the pre-deformed section 15 of the probe 14.

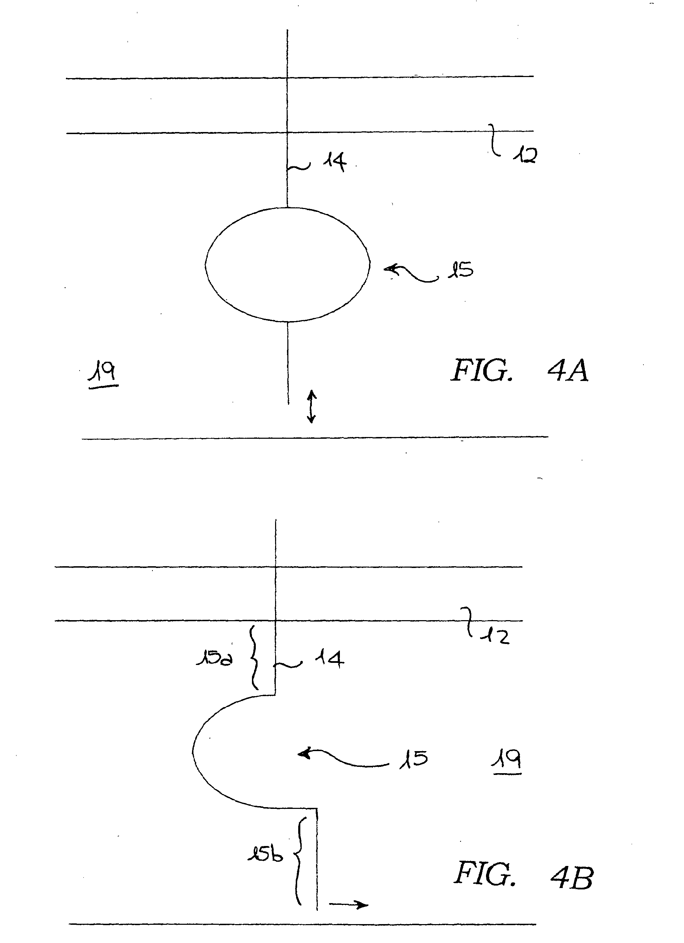

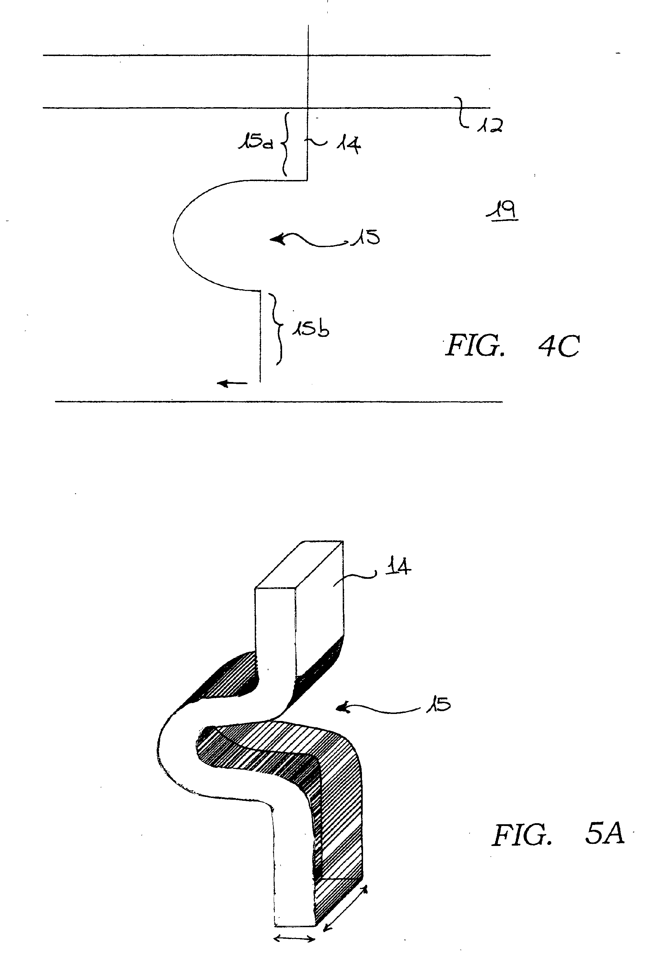

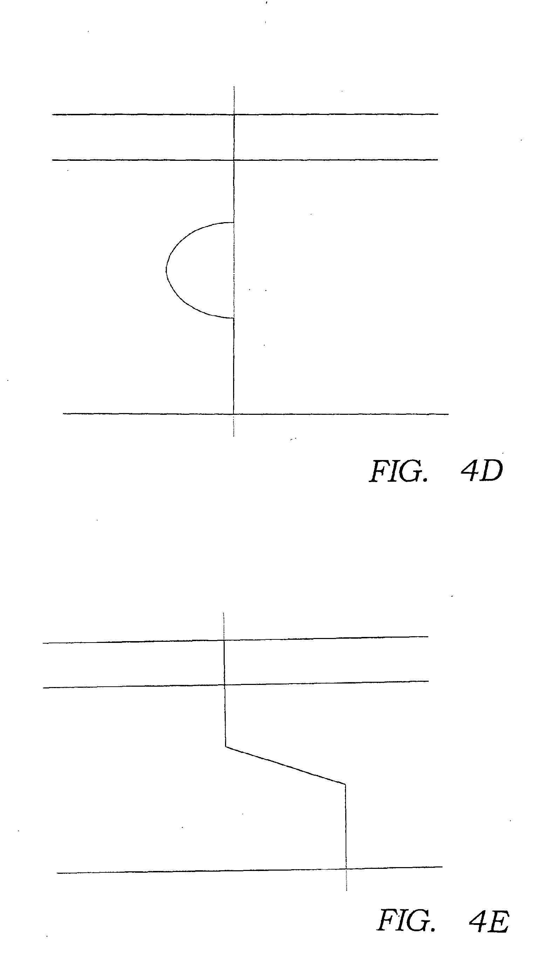

Shown in Figures 4A, 4B, 4C, 4D and 4E are representative embodiments of the testing head 10 according to the invention, specifically providing a range of different shapes for the pre-deformed section 15 of the probe 14.

In particular, the probe shown in Figure 4A has its pre-deformed section 15 symmetrical and essentially oval in shape. The contact tip of this probe makes no horizontal movement (scrub), and the probe vertical movement (overtravel) is taken up by a deformation occurring in its pre-deformed section 15, which is in any case symmetrical.

With this configuration, a horizontal movement (scrub) having a preset amount and direction can be obtained by using a pre-deformed section 15 having one leg with a different cross-section from the other or mirror-image leg.

The probes shown in Figures 4B, 4C and 4E have each a pre-deformed section 15 of asymmetrical shape, and first and second slanted (e.g. vertical) extensions 15a and 15b that are suitably offset from each other to cause the horizontal movement (scrub) to occur along a given direction. It is also possible to use a probe 14 having a C-shaped pre-deformed section 15, such section having the first 15A and second 15B extensions suitably slanted (e.g. vertical), so that a horizontal movement (scrub) occurs, which depends on the contact geometry, as shown in Figure 4D.

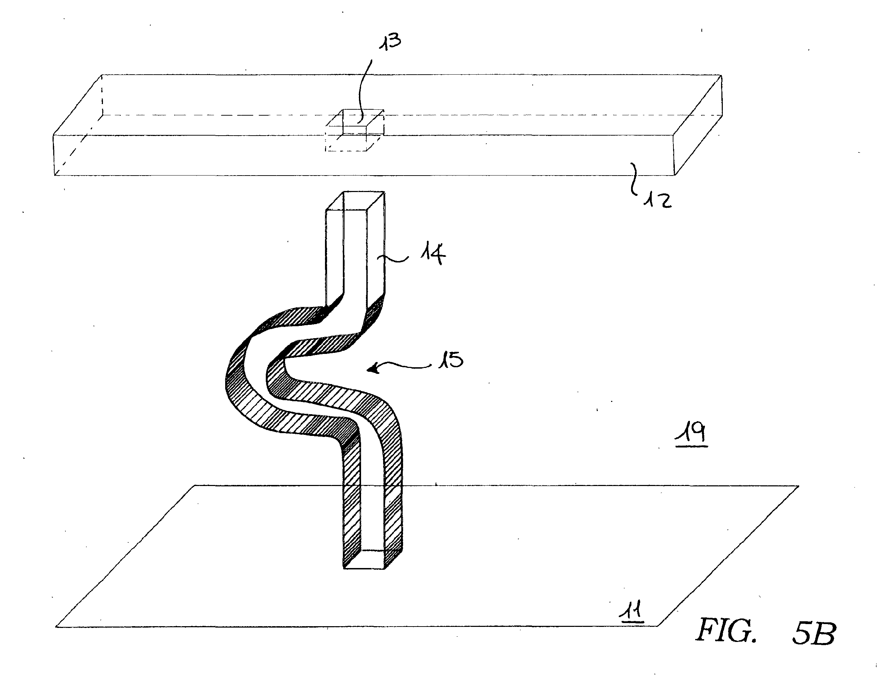

Advantageously in this invention, the probes 14 may be formed with a non-circular cross-sectional shape. In a preferred embodiment, schematically shown in Figures 5A and 5B, a probe 14 with a rectangular cross-sectional shape is provided. In this case, its corresponding guide hole 13 in the plate 12 should also have a rectangular cross-sectional shape, the probes 14 passing through such holes being always aligned to the contact pads 17 of the device 11 to be tested.

With the rectangular cross-sectional probe shown in Figure 5A, the deformed of the probe 14 in the plane of the pre-deformed section 15 is better controlled when the probe contacts the device 11 to be tested, the movement occurring in a predetermined plane such that different rectangular cross-sectional probes will retain the same orientation during their vertical or overtravel movement.

Major advantages of a probe 14 formed with a non-circular cross-section are:
- a better orientation of the probes at the testing head assembling phase by reason of the match provided between the guide holes and the probes;
- a better controlled deformation during the contact of the probe tip to the pads of a device to be tested; and
- easier replacement of faulty probes in a self-centred position, once the relative positions of the guide holes and the contact pads are set, and accordingly, more convenient servicing of the testing head.

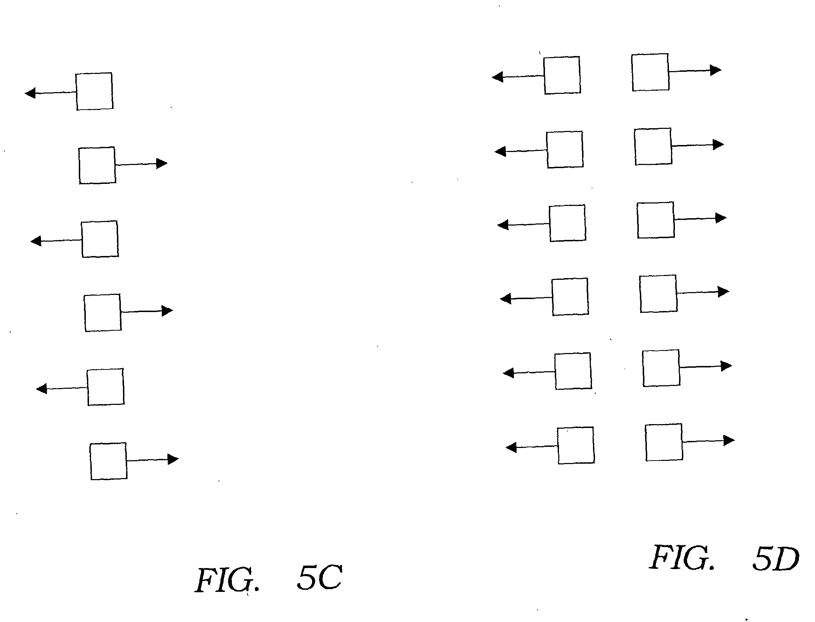

Advantageously in this invention, a testing head 10 carries a plurality of probes 14 formed with a pre-deformed section 15 and orientated according to a symmetrical pattern of their deformed sections relative to a row of contact pads, as shown in Figure 5C, or according to a mirror-image pattern relative to two adjacent rows of contact pads, as shown in Figure 5D, minimising the bulk dimensions of the plurality of probes and, therefore, of the testing head.

In a preferred embodiment, such testing head 10 having the probes 14 orientated according to a symmetrical pattern, for example, is formed by means of non-circular cross-section probes 14 for more convenient orientation of the deformed sections, each rotated through a suitable angle, e.g. 180°, one from the other. In particular, the cross-sectional shape is a rectangle with the small side in the same plane as the deformed section, as shown in Figure 5A, to have the probe 14 oriented in the right direction, even when the probe is deformed.

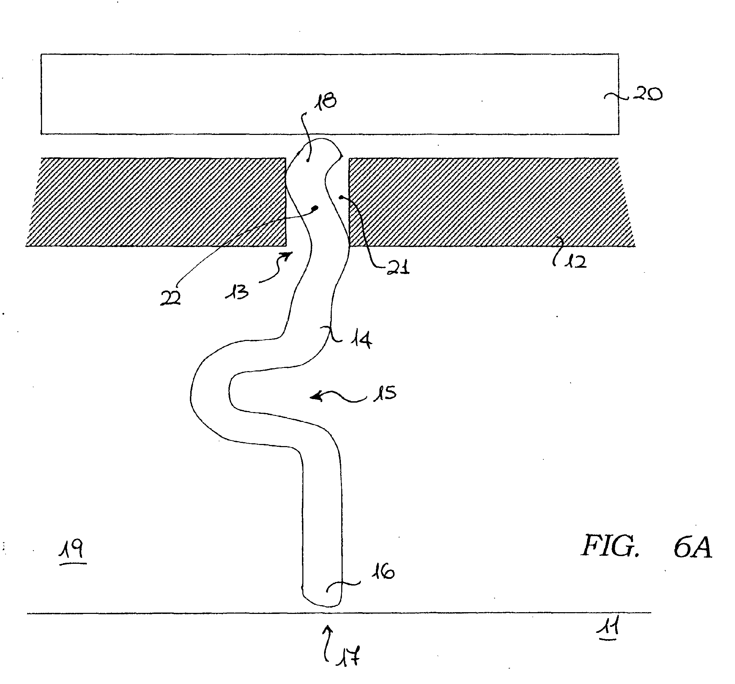

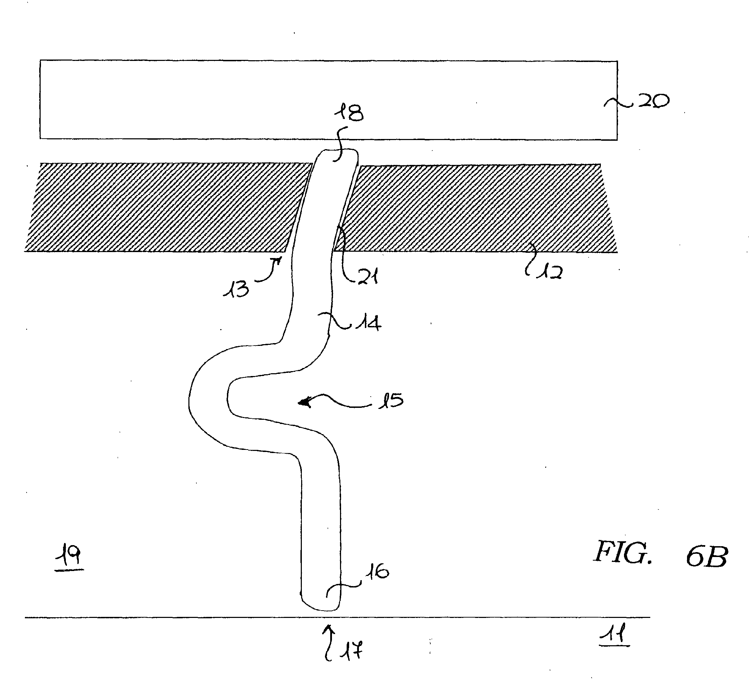

In a further embodiment of the probes 14 of the testing head 10 according to the invention, as schematically shown in Figures 6A and 6B, an area 21 of frictional engagement of the probe in its guide hole 13 through the guide plate 12 is provided to prevent the probe from dropping off the guide hole 13 while no device 11 to be tested is positioned.

This further embodiment is specially suitable for use with a space transformer 20, wherein the probe 14 is held in the guide 12 only by frictional engagement.

In particular, the probe 14 is provided with an additional pre-deformed section 22 extending inside the guide hole 13, as shown in Figure 6A, to form the area 21 of frictional engagement of the probe 14 in the guide hole 13.

A target amount of frictional engagement is obtained by suitably selecting the shape of this additional pre-deformed section 22 and the dimensions of its guide hole 13.

Alternatively, the area 21 of frictional engagement could be provided by using guide holes 13 slanting from a perpendicular line to the plane containing the device 11 to be tested, i.e. from the vertical lay of the probes 14, as schematically shown in Figure 6B. In the same manner, curvilinear guide holes 13 could be also considered.

In a further embodiment of the testing head 10 according to the invention, slanting or curvilinear guide holes are used for probes 14 incorporating said additional pre-deformed section 22, so as to increase the frictional engagement generated in said area 21 of frictional engagement of the probe 14 in the guide hole 13.

It would be also possible, of course, to provide the guide plate 12 with a top guide hole having an S-like pattern; or guide holes with different patterns could be provided, e.g. a curvilinear pattern, for increasing the frictional engagement of the probes in the guide holes.

It should be noted that, although a single guide plate 12 accommodating the probes 14 has been described thus far, several such guide plates could be used instead.

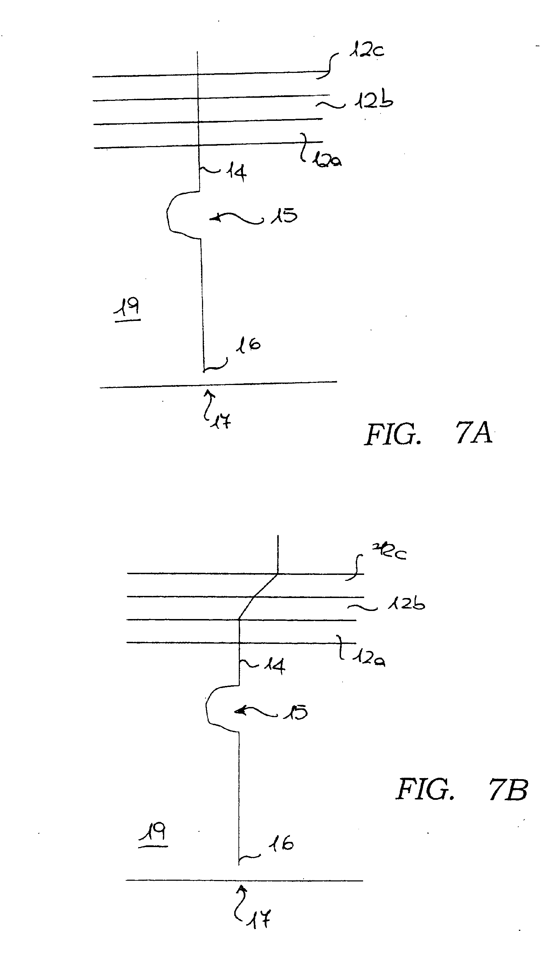

In further embodiments of the testing head 10 according to the invention, two or more juxtaposed guide plates 12a, 12b,..., 12n are used, which are suitably offset from one another to create a combined area 21a of frictional engagement between the probes 14 and the guide plates 12a, 12b,..., 12n, as schematically shown in Figures 7A and 7B.

The guide plates 12a, 12b,..., 12n are in mutual contact relationship, and can be assembled such that each guide hole and each area 21 of frictional engagement have non-straight patterns, according to more or less complicated forms, to increase the probe 14 retaining force in the guide plates.

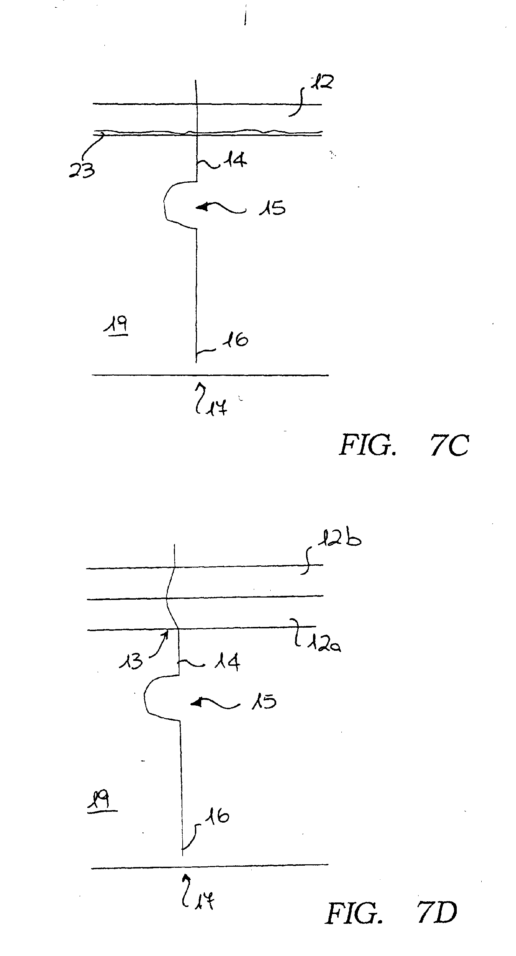

It would also be possible to overlie the guide plate 12 with an elastic film 23 to increase the probe 14 retaining force inside the guide hole 13, as schematically shown in Figure 7C.

This elastic film 23 would increase the probe-to-hole friction force, and with it, the probe retaining force in the guide plate.

Finally, two or more juxtaposed guide plates 12a, 12b,..., 12n, not offset from each other, could be used to receive at least one probe 14 provided with an additional pre-deformed section 22 for retaining the probe within the guide holes 13, as schematically shown in Figure 7D.

It should be emphasised that the embodiments of the testing head 10 according to the invention described hereinabove increase the probes 14 retaining force within the guide holes 13 without interfering with any of the operations for replacing faulty probes 14, the operations of pulling out and pulling in the probes 14 being here much simpler to perform than in conventional designs, due to the pre-deformed section 15 having been located outside the testing head 10.

To summarise, the testing head 10 comprises at least one probe 14 having a pre-deformed section 15 located in a flexion region 19 outside the testing head 10, on the same side as a device 11 to be tested. The flexion of this pre-deformed section can take up the probe 14 vertical movement or overtravel upon the probe tip 16 contacting a pad 17 of the device 11 to be tested, whether or not the probe overtravel is accompanied by a horizontal movement or scrub of the contact tip 16 depending on the shape of the pre-deformed section 15.

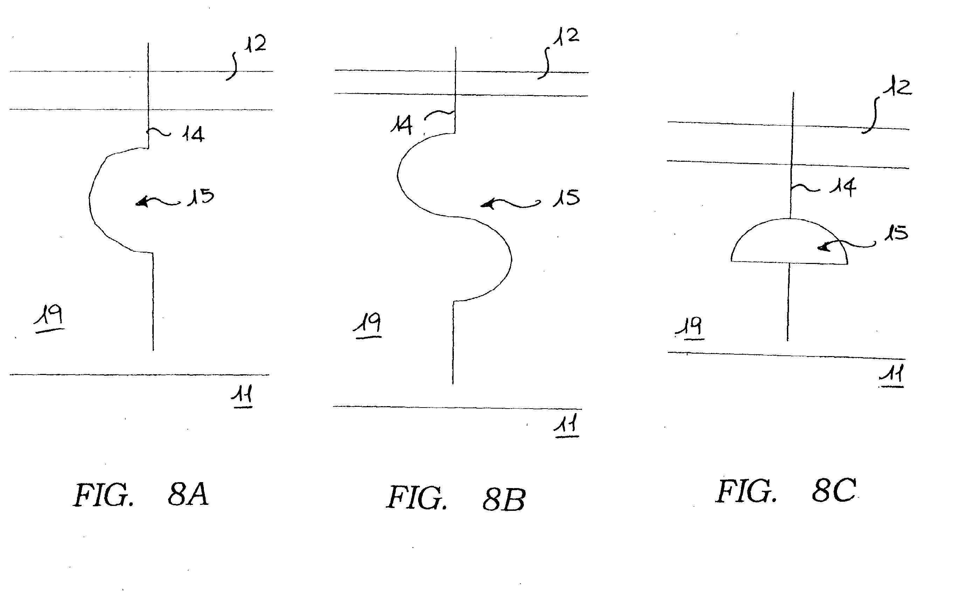

Broadly speaking, pre-deformed sections 15 with different dimensions and symmetrical or asymmetrical shapes may be provided, of which some non-limitative examples are shown in Figures 8A, 8B and 8C. It is understood, however, that these examples are not exhaustive of all possible shapes for the pre-deformed sections 15 of the probes 14 of a testing head 10 according to the invention.

## Claims

1. Testing head (10) having vertical probes and comprising at least one guide plate (12) providing at least one guide hole (13) adapted to receive at least one contact probe (14), in turn having at least one contact tip (16) being suitable to mechanically and electrically contact a corresponding contact pad (17) of a device (11) to be tested, **characterised in that** said contact probe (14) has at least one pre-deformed section (15) placed in a flexion region (19) between the guide plate (12) and the device (11) to be tested, said pre-deformed section being able to further deform during the normal operation of the testing head (10) upon said contact tip (16) abutting against said contact pad (17) of the device (11) to be tested.

2. Testing head (10) having vertical probes according to Claim 1, **characterised in that** it comprises a plurality of probes (14) having pre-deformed sections (15) symmetrically orientated with a row of contact pads (17).

3. Testing head (10) having vertical probes according to Claim 1, **characterised in that** it comprises a plurality of probes (14) having pre-deformed sections (15) orientated in mirror-image relationship with two rows of contact pads (17), even adjacent.

4. Testing head (10) having vertical probes according to any of the Claims 1 to 3, **characterised in that** an area (21) of frictional engagement is provided between said probe (14) and said guide hole (13) to prevent the probe (14) from dropping off the guide hole (13) when no device to be tested is positioned.

5. Testing head (10) having vertical probes according to Claim 4, **characterised in that** said probe (14) comprises an additional pre-deformed section (22) lying inside said guide hole (13) to enhance the frictional engagement in said area (21).

6. Testing head (10) having vertical probes according to Claim 4, **characterised in that** said guide hole (13) is slanted from a perpendicular line to the plane containing the device (11) to be tested, i.e. from the vertical lay of the probes (14), so that said area (21) of frictional engagement is produced.

7. Testing head (10) having vertical probes according to Claim 4, **characterised in that** said guide hole (13) is curvilinear from the perpendicular line to the plane containing the device (11) to be tested, i.e. from the vertical lay of the probes (14), so that said area (21) of frictional engagement is produced.

8. Testing head (10) having vertical probes according to Claim 4, **characterised in that** said probe (14) comprises an additional pre-deformed section (22) provided within said guide hole (13), and that said guide hole (13) is either slant from a perpendicular line to the plane containing the device (11) to be tested, or is curvilinear, so that said area (21) of frictional engagement is produced.

9. Testing head (10) having vertical probes according to Claim 1, **characterised in that** said pre-deformed section (15) is symmetrical in shape.

10. Testing head (10) having vertical probes according to Claim 1, **characterised in that** said pre-deformed section (15) is asymmetrical in shape.

11. Testing head (10) having vertical probes according to Claim 9, **characterised in that** said pre-deformed section (15) is essentially oval and symmetrical in shape.

12. Testing head (10) having vertical probes according to Claim 10, **characterised in that** said pre-deformed section (15) is C-shaped with suitably slanted first (15a) and second (15b) extensions that are aligned to each other.

13. Testing head (10) having vertical probes according to Claim 10, **characterised in that** said pre-deformed section (15) is C-shaped with first (15a) and second (15b) vertical extensions that are aligned to each other.

14. Testing head (10) having vertical probes according to Claim 10, **characterised in that** said pre-deformed section (15) is C-shaped with first (15a) and second (15b) extensions that are suitably slanted and offset from each other.

15. Testing head (10) having vertical probes according to Claim 10, **characterised in that** said pre-deformed section (15) is C-shaped with first (15a) and second (15b) vertical extensions that are suitably offset from each other.

16. Testing head (10) having vertical probes according to any of the Claims 1 to 15, **characterised in that** it comprises two or more guide plates (12a,12b,...,12n) arranged in mutual contact relationship to provide said guide hole (13).

17. Testing head (10) having vertical probes according to Claim 16, **characterised in that** said guide plates (12a,12b,...,12n) are mutually offset so that a guide hole with a non-straight section is provided.

18. Testing head (10) having vertical probes according to any of the Claims 1 to 17, **characterised in that** an elastic film (23) overlies said guide plate (12) for enhancing the retaining force of said probe (14) in said guide hole (13).

19. Testing head (10) having vertical probes according to any of the Claims 1 to 18, **characterised in that** said probe (14) has a non-circular cross-sectional section.

20. Testing head (10) having vertical probes according to any of the Claims 1 to 18, **characterised in that** said probe (14) has a rectangular cross-sectional shape.

21. Testing head (10) having vertical probes according to any of Claims 1 to 18, **characterised in that** said probe (14) has a rectangular cross-sectional shape with the small side of the rectangle lying on the same plane as said pre-deformed section (15).
